# EUROPEAN PATENT APPLICATION

(11) **EP 4 832 699 A1**
(43) Date of publication of application: **28.10.2026**
(21) Application number: 25212546.3
(22) Date of filing: 31.10.2025
(51) Int. Cl.: H10F 77/20

(54) **BACK CONTACT SOLAR CELL AND BACK CONTACT SOLAR CELL MODULE**

(30) Priority: 21.04.2025 CN 202510496518
(71) Applicant: Jinko Solar (Haining) Co., Ltd., Haining City, Zhejiang 314415 (CN)
(72) Inventor: WANG, Luchuang, Haining, 314415 (CN); PENG, Yingying, Haining, 314415 (CN); FANG, Sheng, Haining, 314415 (CN)
(74) Representative: Hautier IP - MC/EP

(57) **Abstract**

Embodiments of the present disclosure relates to the field of photovoltaic technologies. Embodiments of the present disclosure provides a back contact solar cell and a back contact solar cell module. The back contact solar cell includes a substrate (1) and electrode lines (2) arranged on the substrate, and the electrode lines includes connection lines (21) and fingers (22). The connection lines (21) are arranged in sequence along the width direction (X), and the fingers (22) are arranged along the length direction (Y). The fingers (22) are electrically connected to the connection lines (21). The connection lines (21) include two first connection lines (211), and second connection lines (212) located between both first connection lines (211). The second connection lines (212) have a first connection segment (212a) located between the connection portions (3), and the first connection line (211) is electrically connected to the second connection line (212) with the same polarity through the second connection segment (4). The width (b) of the first connection line (211) is greater than the width (a) of the first connection segment (212a), and the width (c) of the second connection segment (4) is greater than the width (a) of the first connection segment (212a). Such a design can reduce the current loss during transmission, thereby facilitating improvement of the efficiency of the back contact solar cell.

## Description

### TECHNICAL FIELD

The present disclosure relates to the field of photovoltaic module technologies, and in particular, to a back contact solar cell and a back contact solar cell module.

### BACKGROUND

With the development of technology, photovoltaic modules have become commonly used devices due to their advantages such as cleanliness and environmental friendliness, environmental protection, renewability, high safety, and long service life. Cells in the photovoltaic modules can generate photogenerated current by absorbing light, so as to supply power to other devices. Generally, the edge positions of the cells have weak capability for current collection. During electroluminescence (EL) testing, the edge positions of the cells are prone to gray, that is, the cell-to-module (CTM) performance of the cells is poor, which affects the efficiency of the cells.

### SUMMARY

Embodiments of the present disclosure provides a back contact solar cell and a back contact solar cell module, which are configured to improve the efficiency of the back contact solar cell.

Embodiments of the present disclosure provides a back contact solar cell, including: a substrate; and electrode lines provided on the substrate.

The electrode lines include a plurality of connection lines and a plurality of fingers; the plurality of connection lines are arranged in sequence along a width direction of the back contact solar cell, the plurality of fingers are arranged in sequence along a length direction of the back contact solar cell, and the connection lines are electrically connected to the fingers; among the connection lines, two of the connection lines are first connection lines, and other connection lines of the connection lines are second connection lines; along the width direction of the back contact solar cell, the first connection lines are located on opposite sides of the back contact solar cell, and the second connection lines are located between the first connection lines; the back contact solar cell further includes connection portions, the second connection lines are connected to the connection portions, one of the second connection lines includes a first connection segment, at least part of the first connection segment is located between adjacent connection portions, one of the second connection lines is a first polarity connection line or a second polarity connection line, the first polarity connection line and the second polarity connection line are spaced apart from each other, and a polarity of the first connection lines is the same as a polarity of the first polarity connection line; and the back contact solar cell includes a second connection segment, the first connection line is electrically connected to a nearest first polarity connection line through the second connection segment.

A width of the first connection segment is a, a width of the first connection lines is b, and a width of the second connection segment is c, where b>a, and c>a.

In one or more embodiments, a width of the first connection line ranges from 50 µm to 150 µm.

In one or more embodiments, a distance between the first connection line and the second connection line adjacent thereto ranges from 300 µm to 400 µm.

In one or more embodiments, along the length direction of the back contact solar cell, a spacing between the fingers located on opposite sides of the second is d, and a width c of the second connection segment satisfies: d-380 µm≤c≤d-300 µm.

In one or more embodiments, a width of the second connection segment ranges from 100 µm to 200 µm.

In one or more embodiments, a width b of the first connection line and a width c of the second satisfy: c>b.

In one or more embodiments, the fingers include first fingers and second fingers, the first fingers are electrically connected to the first connection lines, and the second fingers are electrically connected to the second connection lines; and a width of the first finger is e, and a width of the second finger is f, where e>f.

In one or more embodiments, a width of the first finger ranges from 10 µm to 30 µm.

In one or more embodiments, a width of the first ranges from 14 µm to 16 µm, and a width of the second finger ranges from 8 µm to 16 µm.

Embodiments of the present disclosure further provides a back contact solar cell module. The back contact solar cell module includes at least one back contact solar cell described above.

Embodiments of the present disclosure provides a back contact solar cell and a back contact solar cell module. The back contact solar cell includes the substrate and the electrode lines arranged on the substrate, and the electrode lines includes the connection lines and the fingers. The connection lines are arranged along the width direction, and the fingers are arranged along the length direction. The fingers are electrically connected to the connection lines. The connection lines includes two first connection lines, and the connection lines located between the first connection lines are the second connection lines. The second connection lines have the first connection segment located between the connection portions, and the first connection line is electrically connected to the second connection line with the same polarity through the second connection segment. The width of the first connection line is greater than the width of the first connection segment, and the width of the second connection segment is greater than the width of the first connection segment. Such a design can reduce the current loss during transmission, thereby facilitating improvement of the efficiency of the back contact solar cell.

### BRIEF DESCRIPTION OF DRAWINGS

In order to better illustrate the technical solutions in embodiments of the present disclosure, the drawings used in the description of embodiments are briefly described as below. It will be apparent that the drawings described below are merely some embodiments of the present disclosure, and other drawings may be obtained by those skilled in the art according to these drawings without paying any creative efforts.
FIG. 1 is a schematic diagram of a back contact solar cell according to one or more embodiments of the present disclosure; and
FIG. 2 is a partial schematic diagram of a back contact solar cell according to one or more embodiments of the present disclosure.

### Reference signs:

1 - substrate;
2 - electrode lines;
   21 - connection line;
      211 - first connection line;
      212 - second connection line;
         212a - first connection segment;
         212b - first polarity connection line;
         212c - second polarity connection line;
         212d - third connection segment;
   22 - finger;
      221 - first finger;
      222 - second finger;
3 - connection portion;
4 - second connection segment.

### DESCRIPTION OF EMBODIMENTS

In order to better understand the technical solutions of the present disclosure, embodiments of the present disclosure are described in detail below in conjunction with the drawings.

It is to be made clear that the described embodiments are only some rather than all of embodiments of the present disclosure. All other embodiments obtained by those skilled in the art without creative efforts according to embodiments of the present disclosure are within the protection scope of the present disclosure.

The terms used in embodiments of the present disclosure are only for the purpose of describing specific embodiments, and are not intended to limit the present disclosure. As used in embodiments of the present disclosure and the appended claims, the singular forms "a/an", "said", and "the" are intended to include the plural forms as well, unless the context clearly indicated otherwise.

It should be understood that the term "and/or" used herein is merely an association relationship describing an associated object, and indicates that there may be three relationships. For example, A and/or B, and may indicate: only A, both A and B, and only B. In addition, the character "/" herein generally indicates that the related objects before and after the character present an "or" relationship.

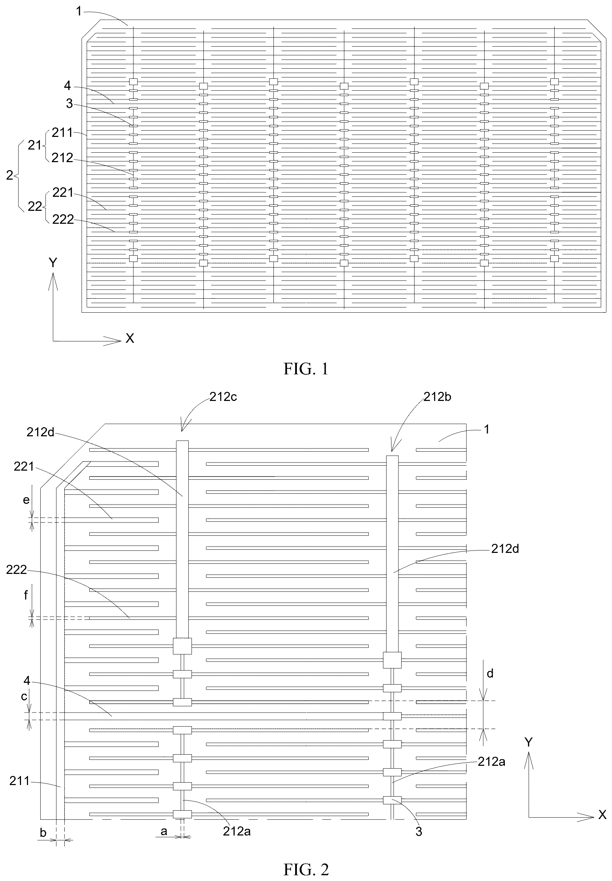

As shown in FIG. 1 and FIG. 2, one or more embodiments of the present disclosure provides a back contact solar cell. The back contact solar cell includes a substrate 1 and electrode lines 2, and the electrode lines 2 are arranged on the substrate 1. The substrate 1 serves as a substrate of the back contact solar cell, and is typically a processed silicon wafer. The substrate 1 can absorb light and generate photogenerated current, and the electrode line 2 is configured to collect the current generated by the substrate 1 and leading the current out. The electrode lines 2 include a plurality of connection lines 21 and a plurality of fingers 22. The connection lines 21 are arranged in sequence along a width direction X of the back contact solar cell. The fingers 22 are arranged in sequence along a length direction Y of the back contact solar cell. The connection lines 21 extend along the length direction Y of the back contact solar cell, and the fingers 22 extend along the width direction X of the back contact solar cell. The connection lines 21 and the fingers 22 may be distributed in a grid pattern on the surface of the substrate 1. Among the plurality of connection lines 21, two of the connection lines 21 are first connection lines 211, and the other connection lines 21 are second connection lines 212. Along the width direction X of the back contact solar cell, the first connection lines 211 are located on opposite sides of the back contact solar cell, and the second connection lines 212 are located between the first connection lines 211. That is, the first connection lines 211 are located on two sides of the substrate 1 close to the edges, and the second connection lines 212 are located between the two first connection lines 211. The first connection lines 211 and the second connection lines 212 are located on the same side of the substrate 1. The back contact solar cell further includes connection portions 3, and the connection portion 3 is configured to be electrically connected to a solder strip. The second connection lines 212 are connected to the connection portions 3. The second connection line 212 includes a first connection segment 212a, and at least part of the first connection segment 212a is located between adjacent connection portions 3. The second connection lines 212 may be divided by polarity into a first polarity connection line 212b and a second polarity connection line 212c, and the first polarity connection line 212b and the second polarity connection line 212c are spaced from each other. That is, the second connection line 212 adjacent to the first polarity connection line 212b is the second polarity connection line 212c, and the second connection line 212 adjacent to the second polarity connection line 212c is the first polarity connection line 212b. The polarity of the first connection line 211 is the same as the polarity of the first polarity connection line 212b. The back contact solar cell further includes a second connection segment 4, and the first connection line 211 is electrically connected to the nearest first polarity connection line 212b through the second connection segment 4. The width of the first connection segment 212a is a, the width of the first connection line 211 is b, and the width of the second connection segment 4 is c, where b>a, and c>a.

In the solution according to embodiments of the present disclosure, through the thickening design of the first connection line 211 and the second connection segment 4, both widths of the first connection line 211 and the second connection segment 4 are greater than the width of the first connection segment 212a. The cross-sectional areas of the first connection line 211 and the second connection segment 4 are increased through the thickening design, thereby reducing the resistance of the first connection line 211 and the second connection segment 4, reducing the current loss, improving the uniformity of EL imaging during EL testing, and improving the CTM performance of the back contact solar cell. Since the current loss of the first connection line 211 and the second connection segment 4 is reduced, the current collection capability of the back contact solar cell at the edge positions can be improved, which is beneficial to improving the overall efficiency of the back contact solar cell and better meets the practical use requirements.

The first connection lines 211 are located at the edge positions of the substrate 1. When the connection portion 3 is arranged on the first connection line 211 to be connected to the solder strip, since the first connection line 211 is located at the edge position of the substrate 1, the difficulty of arranging the solder strip is relatively high. In addition, since the solder strip is located at the edge position of the back contact solar cell, it is prone to damage, which affects normal use of the back contact solar cell. Therefore, the current of the first connection line 211 may be transmitted to the second connection line 212 of the same polarity by providing the second connection segment 4, and the current may be led out through the connection portions 3 arranged on the second connection line 212. The first connection line 211 may not need to be directly electrically connected to the solder strip, thereby saving costs and reducing the possibility of damage to the solder strip.

In one or more embodiments, the width of the first connection line 211 ranges from 50 µm to 150 µm. The width of the first connection line 211 may be 50 µm, 60 µm, 70 µm, 80 µm, 90 µm, 100 µm, 110 µm, 120 µm, 130 µm, 140 µm, 150 µm, or the like.

The width of the first connection line 211 is configured to be 50 µm to 150 µm, so that the resistance of the first connection line 211 can be reduced to decrease the current loss. In addition, the width of the first connection line 211 is within a suitable range, which can reduce the amount of silver paste, thereby reducing costs. When the width of the first connection line 211 is too large, the substrate 1 may be also blocked, which affects the light-receiving area of the back contact solar cell. When the width of the first connection line 211 is too small, the loss the loss during current transmission is relatively high. Therefore, when the width of the first connection line 211 ranges from 50 µm to 150 µm, the current loss can be reduced while lowering costs, and improve the efficiency of the back contact solar cell, which better meets the practical use requirements.

As shown in FIG. 2, in one or more embodiments, the distance between the first connection line 211 and the second connection line 212 adjacent thereto ranges from 300 µm to 400 µm. The distance between the first connection line 211 and the second connection line 212 may be 300 µm, 310 µm, 320 µm, 330 µm, 340 µm, 350 µm, 360 µm, 370 µm, 380 µm, 390 µm, 400 µm, or the like.

The distance between the first connection line 211 and the second connection line 212 is configured to be 300 µm to 400 µm, so as to improve the current collection capability of the back contact solar cell at the edge positions. When the distance between the first connection line 211 and the second connection line 212 is too large, the transmission distance of the current increases, resulting in increased loss during transmission. When the distance between the first connection line 211 and the second connection line 212 is too small, the current distribution becomes prone to non-uniformity, and the risk of short circuit is increased. Therefore, the distance between the first connection line 211 and the adjacent second connection line 212 ranges from 300 µm to 400 µm.

As shown in FIG. 2, in one or more embodiments, along the length direction Y of the back contact solar cell, the spacing between the fingers 22 located on two opposite sides of the second connection segment 4 is d, and the width c of the second connection segment 4 satisfies: d-380 µm≤c≤d-300 µm. The width c of the second connection segment 4 may be d-380 µm, d-370 µm, d-360 µm, d-350 µm, d-340 µm, d-330 µm, d-320 µm, d-310 µm, d-300 µm, or the like.

The spacing between the second connection segment 4 and the finger 22 is configured to satisfy the relationship of d-380 µm≤c≤d-300 µm, so as to increase the width of the second connection segment 4 to reduce the resistance of the second connection segment 4, thereby reducing the current loss. In addition, the sufficient spacing may be provided between the second connection segment 4 and the adjacent finger 22 may, so as to reduce the possibility of short circuit between the second connection segment 4 and the finger 22, thereby improving the operational stability and working efficiency of the back contact solar cell, and better meeting the practical use requirements.

In one or more embodiments, the spacing between the fingers 22 connected to the same connection line 21 may also be d. Such an arrangement facilitates the uniform distribution of the fingers 22 in the substrate, thereby facilitating the improvement of the current collection efficiency.

As shown in FIG. 2, in one or more embodiments, the width of the second connection segment 4 may ranges from 100 µm to 200 µm. The width of the second connection segment 4 may be 100 µm, 110 µm, 120 µm, 130 µm, 140 µm, 150 µm, 160 µm, 170 µm, 180 µm, 190 µm, 200 µms, or the like.

When the width of the second connection segment 4 is too small, the resistance of the second connection segment 4 is relatively large. According to Joule's Law: Q = I²Rt, where Q represents heat, I represents current, R represents resistance, and t represents time. When the resistance of the second connection segment 4 increases, the heat generated per unit time increases, leading to an increase in the current loss, thereby affecting the efficiency of the back contact solar cell. When the width of the second connection segment 4 is too large, the cost of materials such as silver paste increases, and the difficulty of soldering also increases. An overly wide second connection segment 4 may also affect the light-receiving area of the back contact solar cell, thereby reducing the efficiency of the back contact solar cell. In addition, when the width of the second connection segment 4 is too large, the second connection segment 4 is also prone to contact with the adjacent fingers 22, resulting in that the back contact solar cell is prone to short circuit. Therefore, the width of the second connection segment 4 may ranges from 100 µm to 200 µm, which can reduce the current loss while also reducing cost, improve the efficiency of the back contact solar cell, and better meet the practical use requirements.

As shown in FIG. 2, in one or more embodiments, the width b of the first connection line 211 and the width c of the second connection segment 4 satisfy c>b.

The second connection segment 4 is configured to lead out the current of the first connection segment 212a. The width of the second connection segment 4 is configured to be greater than the width of the first connection line 211, so as to further reduce the resistance of the second connection segment 4, thereby reducing the current loss during current transmission, and improving the efficiency of the back contact solar cell.

As shown in FIG. 2, in one or more embodiments, the fingers 22 include first fingers 221 and second fingers 222. The first finger 221 is electrically connected to the first connection line 211, and the second finger 222 is electrically connected to the second connection line 212. The width of the first finger 221 is e, and the width of the second finger 222 is f, where e>f.

The first finger 221 is connected to the first connection segment 212a located at the edge position of the back contact solar cell, and is configured to collect the current at the edge position of the back contact solar cell. The width of the first finger 221 is configured to be greater than the width of the second finger 222, so that the resistance of the first finger 221 can be reduced, thereby reducing the current loss, and improving the current collection capability of the first finger 221 for the edge position of the back contact solar cell. As a result, the grayish appearance at the edge positions of the back contact solar cell during EL testing can be improved.

In one or more embodiments, the width of the first finger 221 ranges from 10 µm to 30 µm. The width of the first finger 221 may be 10 µm, 12 µm, 14 µm, 16 µm, 18 µm, 20 µm, 22 µm, 24 µm, 26 µm, 28 µm, 30 µm, or the like.

When the width of the first finger 221 is too small, the resistance of the first finger 221 is relatively large, so that the current loss is relatively large, resulting ina reduction in the efficiency of the back contact solar cell. When the width of the first finger 221 is too large, the cost of the first finger 221 increases, and the first finger 221 is prone to contacting other electrode lines 2, resulting in the short circuit of the back contact solar cell. Therefore, the width of the first finger 221 ranges from 10 µm to 30 µm, which can improve the current collection capability of the first finger 221 and reduce the current loss, and can also reduce the costs and improve the efficiency of the back contact solar cell.

In one or more embodiments, the width of the first connection segment 212a ranges from 14 µm to 16 µm, and the width of the second finger 222 ranges from 8 µm to 16 µm. The width of the first connection segment 212a may be 14.0 µm, 14.2 µm, 14.4 µm, 14.6 µm, 14.8 µm, 15.0 µm, 15.2 µm, 15.4 µm, 15.6 µm, 15.8 µm, 16.0 µm, or the like. The width of the second finger may be 8 µm, 9 µm, 10 µm, 11 µm, 12 µm, 13 µm, 14 µm, 15 µm, 16 µm, or the like.

The first connection segment 212a may serve as a busbar or an integral part of the busbar for leading out the current collected by the finger 22. When the width of the first connection segment 212a is too small, the resistance of the first connection segment 212a increases, and the heat generated during current transmission increases, thereby leading to an increase in the current loss. When the width of the first connection segment 212a is too large, the area of the substrate 1 blocked by the first connection segment 212a is relatively large, which can affect the light-receiving area of the back contact solar cell, thereby resulting in relatively low efficiency of the back contact solar cell. The width of the first connection segment 212a is configured to be 14 µm to 16 µm, which can reduce the current loss, and also reduce the blocking of the substrate 1 by the first connection segment 212a, thereby improving the efficiency of the back contact solar cell.

The width of the second finger 222 ranges from 8 µm to 16 µm, which can improve the current collection capability of the second finger 222, thereby improving the efficiency of the back contact solar cell, and better meeting the practical use requirements.

In one or more embodiments, the width of the first connection line 211 is 75 µm, and the width of the second connection segment 4 is 100 µm. That is, the width of the second connection segment 4 is greater than the width of the first connection line 211, the width of the first connection line 211 is greater than the width of the first finger 221, and the width of the first finger 221 is greater than the width of the second finger 222.

In related art, the width of the first connection line 211 and the width of the second connection segment 4 are generally the same as the width of the first connection segment 212a, and the width of the first finger 221 and the width of the second finger 222 are also the same. The first connection line 211 located at the edge position needs to converge the current to the second connection line 212 having the same polarity as the first connection line 211. The current collected by the second connection line 212 can be led out through the connection portion 3 and the solder strip. The transmission distance of the current in the first connection line 211 is relatively long, and the current is relatively large. Therefore, the current loss generated when the current is transmitted in the first connection line 211 is also relatively large. When the EL testing is performed on the back contact solar cell, the grayness appears at the edge position of the back contact solar cell, that is, the CTM performance of the back contact solar cell is relatively poor, and the efficiency of the back contact solar cell is relatively low.

In the solution according to embodiments of the present disclosure, through the thickening design of the first connection line 211, the second connection segment 4, and the first finger 221, the resistance of the first connection line 211, the second connection segment 4, and the first finger 221 can be reduced. According to Joule's Law, when the resistance decreases, the heat generated per unit time decreases. Therefore, through the thickening design of the first connection line 211, the second connection segment 4, and the first finger 221, the current loss during transmission can be reduced, thereby ensuring the uniformity of EL imaging, improving the grayness at the edge positions of the back contact solar cell during the EL testing, further improving the CTM of the back contact solar cell, and enhancing the efficiency of the back contact solar cell. The second connection segment 4, as a through line of the back contact solar cell, is configured to converge the current of the first connection line 211 to the second connection line 212, and lead out the current through the connection portion 3. That is, the current of the first connection line 211 needs to converge from the second connection segment 4 to the second connection line 212. As a result, the second connection segment 4, which serves to converge the current, should be wider than the first connection line 211 to reduce the current loss.

That the width of the first finger 221 is greater than the width of the second finger 222 can improve the current collection capability of the first finger 221 for the edge position of the back contact solar cell, and can also reduce the resistance of the first finger 221 by increasing the width of the first finger 221, thereby reducing the heat generated during current transmission, so as to reduce the current loss. By adopting the first connection line 211 and the second connection segment 4 that have a greater width, the current loss during transmission can be further reduced, thereby improving the efficiency of the back contact solar cell. The second connection line 212 may further include a third connection segment 212d. The third connection segment 212d is at least arranged at one end of the first connection segment 212a, and the width of the third connection segment 212d is greater than the width of the first connection segment 212a. In one or more embodiments, the width of the third connection segment 212d may be greater than the width of the first connection lines 211, and the width of the third connection segments 212d is larger than the width of the second connection segments 4.

By at least providing the third connection segment 212d at one end of the first connection segment 212a, the second connection line 212 may form a structure that is wider at the end portions and narrower in the middle. Such a design is beneficial to improving the current collection capability and transmission capability of the electrode line 2 at the edge positions of the back contact solar cell, thereby improving the efficiency of the back contact solar cell and better meeting the practical use requirements.

Embodiments of the present disclosure further provides a back contact solar cell module. The back contact solar cell module includes at least one back contact solar cell, and the back contact solar cell may be the back contact solar cell according to any one of the above embodiments. Since the back contact solar cell has the above technical effects, the back contact solar cell module including the back contact solar cell also has corresponding technical effects, which will not be repeated herein.

The back contact solar cell module may further include structures such as a first cover plate, a second cover plate, a first adhesive film, and a second adhesive film. A plurality of back contact solar cells are electrically connected to form a back contact solar cell string, and a plurality of back contact solar cell strings are electrically connected to form a back contact solar cell array. Along the thickness direction of the back contact solar cell module, the first adhesive film and the second adhesive film are located on opposite sides of the back contact solar cell array. The first cover plate is located on a side of the first adhesive film away from the back contact solar cell array, and the second cover plate is located on a side of the second adhesive film away from the back contact solar cell array. The first cover plate and the second cover plate are located on the surface of the back contact solar cell module, and can protect the back contact solar cell module. The first adhesive film and the second adhesive film can play a buffering effect to reduce the possibility of microcracks in the back contact solar cell during lamination and collision, thereby facilitating prolonging the service life of the back contact solar cell module.

Adjacent back contact solar cells may be connected through the solder strip. The finger 22 is configured to collect the photogenerated current generated by the substrate, and the connection line 21 is configured to collect the current from the finger 22. The connection line 21 is connected to the solder strip to enable the current to be led out.

In one or more embodiments, adjacent solar cells may also be connected using a conductive adhesive. The conductive adhesive has good conductivity and adhesiveness. The conductive adhesive is coated on the electrodes of the solar cell, and then a conductive path can be formed by pressing and curing, thereby realizing electrical connection. The connection through the conductive adhesive can reduce the influence of thermal stress on the back contact solar cell during the connection process and the possibility of mechanical damage, which is beneficial to improving the reliability and stability of the back contact solar cell module. In the actual production process, the solder strip can be used in combination with the conductive adhesive to save costs and improve reliability.

The first cover plate and the second cover plate have relatively high structural strength, providing a certain mechanical strength and rigidity for the back contact solar cell module, so as to protect the adhesive film, the back contact solar cell and other components inside the back contact solar cell module, to reduce the influence of environmental factors such as rainwater, wind and sand, and dust on the back contact solar cell module, and to reduce the possibility of the back contact solar cell module being corroded, abraded, or aged, thereby facilitating prolonging the service life of the back contact solar cell module.

When one side of the back contact solar cell module is a light-receiving side and the other side of the back contact solar cell module is a rear side, the first cover plate is located on the light-receiving side, and the second cover plate is located on the rear side. The material of the first cover plate is a light-transmitting material, and the material of the second cover plate is a reflective material or is provided with a reflective layer. Light can pass through the first cover plate and the first adhesive film to reach the back contact solar cell and be absorbed by the back contact solar cell, so as to generate photogenerated current. The light that is not absorbed by the back contact solar cell can be reflected by the second cover plate after passing through the second adhesive film, so that the light can again be transmitted to the back contact solar cell for absorption by the back contact solar cell, thereby improving the light absorption efficiency of the back contact solar cell, and further improving the efficiency of the back contact solar cell.

When both sides of the back contact solar cell are light-receiving sides, the material of the first cover plate and the material of the second cover plate are both light-transmitting materials. Such a design is conducive to increasing the light-receiving area of the back contact solar cell module, thereby improving efficiency.

The material of the cover plate may be tempered glass or the like, which provides good strength while also offering good light transmittance. When the tempered glass is used as the second cover plate, light reflection can be realized by providing a reflective film, a reflective coating and the like on the surface of the tempered glass, so as to improve efficiency.

The first adhesive film and the second adhesive film may be Ethylene-Vinyl Acetate (EVA) adhesive film, Polyolefin Elastomer (POE) adhesive film, EPE adhesive film (EVA-POE-EVA co-extruded adhesive film), or the like. The adhesive films are located between the cover plates and the solar cells, and provides bonding and fixing therebetween, so that the various components of the back contact solar cell module can form an integrated whole, thereby reducing the possibility of delamination and falling off of the back contact solar cell module during use. The adhesive film can also provide a seal, reducing the possibility that external substances such as moisture and oxygen enter the interior of the back contact solar cell module, thereby reducing the possibility that the back contact solar cell and other components are corroded and oxidized, which is beneficial to prolonging the service life and reliability of the back contact solar cell module.

The adhesive film can also perform a certain degree of refraction and scattering on light, so that the light can be better propagated and utilized inside the module, thereby facilitating improving the light absorption efficiency of the back contact solar cell, facilitating improving the efficiency of the back contact solar cell module, and better meeting the practical use requirements. The solar cell according to embodiments of the present disclosure is a back contact solar cell. The positive and negative electrodes of the back contact solar cell are both provided on the back surface of the substrate, namely the rear side of the back contact solar cell. Such a design can reduce the blocking of the light-receiving side of the substrate 1 by the electrode line 2, which is beneficial to increasing the light-receiving area of the substrate 1, thereby improving the photoelectric conversion efficiency. In addition, since the electrodes are concentrated on the same side of the substrate 1, the transmission path of the current when collecting the current, which is beneficial to reducing the current loss during transmission, and can improve the fill factor and conversion efficiency of the solar cell, thereby better meeting the practical use requirements. By arranging the electrodes on the rear side of the substrate 1, the possibility that the electrodes are corroded and damaged in outdoor and other environments can be reduced. By arranging the electrodes on the rear side, the influence of illumination and ultraviolet rays on the electrodes can be reduced, and the rate of electrode aging and performance degradation is reduced, thereby prolonging the service life of the solar cell, and improving the reliability of the solar cell. The front surface of the back contact solar cell usually has no electrode line, so that the possibility of stress concentration caused by differences in coefficients of thermal expansion can be reduced, thereby reducing the possibility of cracking and damage of the back contact solar cell during use.

Embodiments of the present disclosure provides a back contact solar cell and a back contact solar cell module. The back contact solar cell includes the substrate 1 and the electrode lines 2 arranged on the substrate 1. The electrode lines 2 include the connection lines 21 and the fingers 22. The connection lines 21 are arranged along the width direction, and the fingers 22 are arranged along the length direction. The connection line 21 includes two first connection lines 211, and the connection lines 21 located between the first connection lines 211 are the second connection lines 212. The fingers 22 include the first fingers 221 and the second fingers 222. The first finger 221 is electrically connected to the first connection line 211, and the second finger 222 is electrically connected to the second connection line 212. The second connection line 212 has the first connection segment 212a located between the connection portions 3, and the first connection line 211 is electrically connected to the second connection line 212 with the same polarity through the second connection segment 4. The width of the first connection line 211 is greater than the width of the first connection segment 212a, and the width of the second connection segment 4 is greater than the width of the first connection segment 212a. Such a design can reduce the current loss during transmission, thereby facilitating improvement of the efficiency of the back contact solar cell.

The foregoing descriptions are merely specific implementations of embodiments of the present disclosure, but the protection scope of embodiments of the present disclosure is not limited thereto, and any change or replacement within the technical scope disclosed in embodiments of the present disclosure shall fall within the protection scope of embodiments of the present disclosure. Therefore, the protection scope of embodiments of the present disclosure should be based on the protection scope of the claims.

## Claims

1. A back contact solar cell, comprising:
a substrate (1);
electrode lines (2) provided on the substrate (1), wherein the electrode lines (2) comprise connection lines (21) and fingers (22); the connection lines (21) are arranged in sequence along a width direction (X) of the back contact solar cell, the fingers (22) are arranged in sequence along a length direction (Y) of the back contact solar cell, and the connection lines (21) are electrically connected to the fingers (22), among the connection lines (21), two of the connection lines (21) are first connection lines (211), and other connection lines of the connection lines (21) are second connection lines (212); along the width direction (X) of the back contact solar cell, the first connection lines (211) are located on two opposite sides of the back contact solar cell, and the second connection lines (212) are located between the first connection lines (211);
connection portions (3), wherein the second connection lines (212) are connected to the connection portions (3), one of the second connection lines (212) comprises a first connection segment (212a), at least part of the first connection segment (212a) is located between adjacent connection portions (3), one of the second connection lines (212) is a first polarity connection line (212b) or a second polarity connection line (212c), the first polarity connection line (212b) and the second polarity connection line (212b) are spaced apart from each other, and a polarity of the first connection lines (211) is the same as a polarity of the first polarity connection line (212b); and
a second connection segment (4), wherein one first connection line (211) of the first connection lines (211) is electrically connected to a nearest first polarity connection line (212b) through the second connection segment (4), and
wherein a width of the first connection segment (212a) is a, a width of the first connection lines (211) is b, and a width of the second connection segment (4) is c, where b>a, and c>a.

2. The back contact solar cell according to claim 1, wherein a width of the first connection line (211) ranges from 50 µm to 150 µm.

3. The back contact solar cell according to claim 1, wherein a distance between the first connection line (211) and a corresponding second connection line (212) of the second connection lines (212) adjacent thereto ranges from 300 µm to 400 µm.

4. The back contact solar cell according to claim 1, wherein along the length direction (Y) of the back contact solar cell, a spacing between two fingers (22) located on opposite sides of the second connection segment (4) is d, and the width c of the second connection segment (4) satisfies: d-380 µm≤c≤d-300 µm.

5. The back contact solar cell according to claim 1, wherein the width c of the second connection segment (4) ranges from 100 µm to 200 µm.

6. The back contact solar cell according to claim 1, wherein a width b of the first connection line (211) and the width c of the second connection segment (4) satisfy: c>b.

7. The back contact solar cell according to claim 1, wherein the fingers (22) comprises first fingers (221) and second fingers (222), the first fingers (221) are electrically connected to the first connection lines (211), and the second fingers (222) are electrically connected to the second connection lines (212); and
a width of one first finger of the first fingers (221) is e, and a width of one second finger of the second fingers (222) is f, where e>f.

8. The back contact solar cell according to claim 7, wherein a width of the first finger (221) ranges from 10 µm to 30 µm.

9. The back contact solar cell according to claim 7, wherein a width of the first connection segment (212a) ranges from 14 µm to 16 µm, and a width of the second finger (222) ranges from 8 µm to 16 µm.

10. The back contact solar cell according to claim 1, wherein the width c of the second connection segment (4) is greater than the width b of the first connection line (211).

11. The back contact solar cell according to claim 8, wherein the width (b) of the first connection line (211) is greater than the width of the first finger (221).

12. A back contact solar cell module, comprising at least one back contact solar cell according to claim 1.

13. The back contact solar cell module according to claim 12, wherein a plurality of back contact solar cells are electrically connected to form a back contact solar cell string, and a plurality of back contact solar cell strings are electrically connected to form a back contact solar cell array.

14. The back contact solar cell module according to claim 12, further comprising a first cover plate, a second cover plate, a first adhesive film, and a second adhesive film,
wherein along the thickness direction of the back contact solar cell module, the first adhesive film and the second adhesive film are located on opposite sides of the back contact solar cell array. The first cover plate is located on a side of the first adhesive film away from the back contact solar cell array, and the second cover plate is located on a side of the second adhesive film away from the back contact solar cell array.

15. The back contact solar cell module according to claim 12, wherein a width of the first connection line (211) ranges from 50 µm to 150 µm.
